Europäisches Patentamt

European Patent Office

Office européen des brevets

(19)

(11) EP 0 729 042 B1

(12) FASCICULE DE BREVET EUROPEEN

(45) Date de publication et mention
de la délivrance du brevet:
**18.12.2002 Bulletin 2002/51**

(51) Int Cl.⁷: **G02B 6/30**, G02B 6/12,
H01S 5/02

(21) Numéro de dépôt: **96400337.0**

(22) Date de dépôt: **19.02.1996**

(54) **Guide optique segmenté pouvant notamment être inclus dans un dispositif semiconducteur**

Segmentierter optischer Leiter, dessen Verwendung insbesondere in einer Halbleitervorrichtung

Segmented optical guide, its use in particular in a semiconductor device

(84) Etats contractants désignés:
**DE ES GB IT NL SE**

(30) Priorité: **22.02.1995 FR 9502045**

(43) Date de publication de la demande:
**28.08.1996 Bulletin 1996/35**

(73) Titulaire: **ALCATEL**
**75008 Paris (FR)**

(72) Inventeurs:
• **Vinchant, Jean-François**
**91680 Bruyères le Châtel (FR)**
• **Goldstein, Léon**
**92370 Chaville (FR)**
• **Leclerc, Denis**
**91430 Igny (FR)**
• **Gentner, Jean L.**
**91191 Gif sur Yvette (FR)**

(74) Mandataire: **Fournier, Michel Robert Marie**
**COMPAGNIE FINANCIERE ALCATEL**
**Département Propriété Industrielle**
**30, avenue Kléber**
**75116 Paris (FR)**

(56) Documents cités:
**EP-A- 0 583 679**

• **ELECTRONICS LETTERS., vol. 30, no. 18, 1
Septembre 1994, ENAGE GB, pages 1515-1516,
XP002004299 J.-M.CHEONG ET.AL.: "High
alignment tolerance coupling scheme for
multichannel laser diode/singlemode fibre
modules using a tapered waveguide array"**
• **IEEE JOURNAL OF QUANTUM ELECTRONICS.,
vol. 30, no. 8, Août 1994, NEW YORK US, pages
1787-1793, XP002004300 O.MITOMI ET.AL.:
"Design of a single-mode tapered waveguide for
low-loss chip-to-fiber coupling"**
• **JOURNAL OF LIGHTWAVE TECHNOLOGY., vol.
5, no. 9, Septembre 1987, NEW YORK US, pages
1277-1285, XP002004301 M.SUZUKI ET.AL.:
"Monolithic integration of InGaAsP/InP"**

**Description**

La présente invention concerne de manière générale un guide optique à plusieurs segments.

Elle concerne plus spécifiquement le raccordement de deux structures guidantes présentant des configurations de confinement différentes. Deux telles structures sont notamment celles d'un ruban enterré et d'un ruban externe formés dans une même plaquette semiconductrice constituant un composant optoélectronique. Les rubans enterré et externe constituent typiquement les guides de lumière d'un laser et d'un modulateur intégrés, la plaquette étant constituée par exemple à base de phosphure d'indium. Ils sont respectivement désignés internationalement par les termes anglais "Buried Heterostructure" ou "BH" pour "heterostructure enterrée" et "ridge" pour "arête". Leurs caractéristiques respectives seront rappelées dans la description ci-après.

D'autres dispositifs peuvent cependant être concernés par cette invention. Ils peuvent être réalisés sur un substrat électro-optique tel que le niobate de lithium ou dans un verre. Ils peuvent inclure des éléments optiques divers et des connexions entre ces éléments qui sont par exemple : des lasers, des diodes émettrices de lumière, des photodiodes, des modulateurs électro-optiques, des segments d'entrée ou de sortie du guide d'un circuit intégré, des fibres optiques, des commutateurs, des coupleurs, des amplificateurs optiques, des miroirs, des filtres, des réseaux de diffraction, et cetera. Certains de ces éléments ou connexions sont réalisés à l'aide de structures guidantes. Une telle structure présente une configuration de confinement définie par les positions et dimensions de ses éléments constitutifs dans un plan transversal et par leurs indices de réfraction. Pour des raisons technologiques ou pour des raisons de performances, cette configuration dépend de l'élément ou connexion à intégrer. Des raccordements doivent donc parfois être réalisés entre des structures guidantes présentant des configurations différentes, ces structures constituant alors des segments successifs d'un même guide optique.

De manière générale de tels raccordements provoquent la perte d'une partie de la lumière guidée. Pour limiter cette perte il est connu d'interposer en série, entre les deux segments de guide constitués par les deux structures guidantes à raccorder, un segment de transition constitué par une structure guidante dont une dimension transversale varie d'une manière progressive d'une extrémité à l'autre de ce segment.

Typiquement, dans le cas des structures guidantes réalisées en technique planaire, à chacune des deux extrémités du segment de transition, la largeur du coeur de ce segment est égale à la largeur du coeur de la structure guidante raccordée à cette extrémité et cette largeur varie linéairement entre ces deux extrémités.

Par ailleurs, pour permettre une fabrication industrielle économique du dispositif le segment de transition doit de préférence être réalisé en même temps et par les mêmes moyens que l'une au moins des structures guidantes à raccorder.

La présente invention a notamment pour but de permettre une réalisation peu coûteuse d'un raccordement provoquant des pertes de lumière faibles au passage entre deux structures guidantes présentant des paramètres optiques différents.

A l'aide des figures schématiques ci-jointes, on va décrire plus particulièrement ci-après, à titre d'exemple non limitatif, comment la présente invention peut être mise en oeuvre. Lorsqu'un même élément est représenté sur plusieurs figures il y est désigné par le même signe de référence.

La figure 1 représente une vue en coupe longitudinale d'une plaquette semiconductrice dans laquelle cette invention doit être mise en oeuvre.

La figure 2 représente une vue de cette plaquette en coupe longitudinale après dépôt d'une couche de délimitation.

La figure 3 représente une vue de dessus de cette plaquette après une gravure de la couche de délimitation et une première attaque de la plaquette.

Les figures 4 et 5 représentent deux vues de cette plaquette en coupe selon deux plans transversaux IV-IV et V-V de la figure 3 après cette première attaque.

Les figures 6 et 7 représentent deux vues de cette plaquette en coupe selon les deux mêmes plans transversaux après une deuxième attaque.

La figure 8 représente une vue de cette plaquette en coupe par le plan transversal IV-IV après remplissage d'évidements latéraux.

Les figures 9 et 10 représentent deux vues de cette plaquette en coupe par les deux mêmes plans transversaux après la formation d'électrodes, cette plaquette constituant alors un dispositif conforme à l'invention.

La figure il représente une vue de dessus d'un guide composite de ce dispositif.

La figure 12 représente un diagramme de la variation d'une perte de lumière dans ce dispositif en fonction d'un excès de largeur d'un segment de guide de ce dispositif.

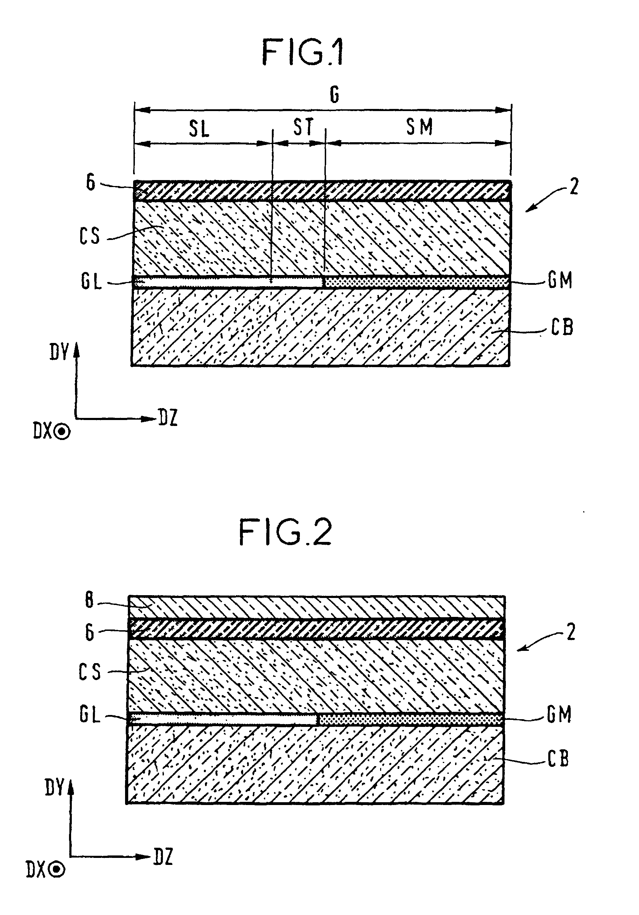

A l'aide des figures 1 à 10 on va tout d'abord indiquer comment un ruban enterré et un ruban externe de ce dispositif peuvent être réalisés, étant entendu que ces rubans constituent deux structures guidantes différentes et que ces deux structures doivent être mutuellement raccordées de manière à constituer une partie arrière et un segment avant d'un guide optique selon l'invention.

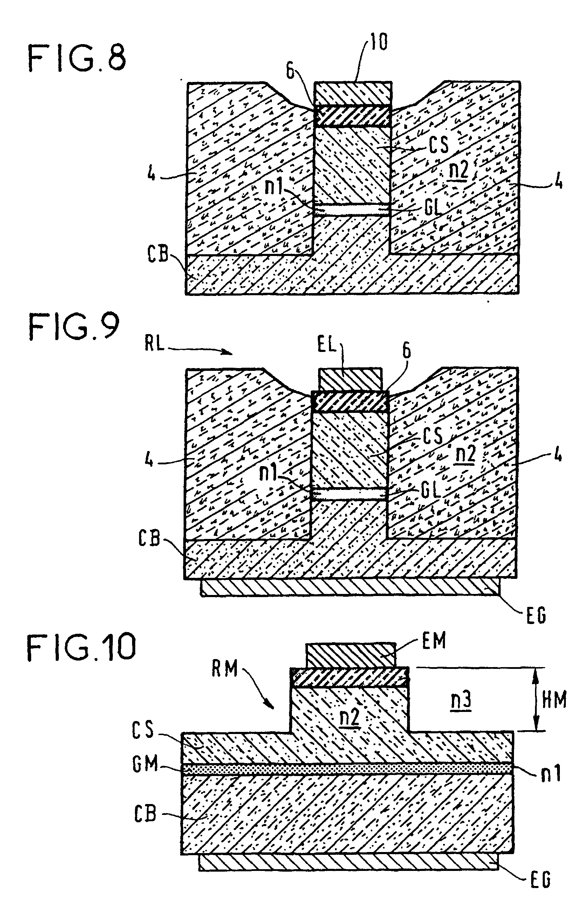

Conformément à ces figures, un dispositif à fabriquer est formé dans un substrat 2. Ce dernier est par exemple, constitué d'une plaquette semiconductrice 2 formée de couches s'étendant selon une direction longitudinale horizontale DZ et une direction transversale DX et superposées selon une direction verticale DY. Ces directions sont définies par rapport à cette plaquette. Cette plaquette comporte un segment à ruban enterré SL un segment de transition ST prolongeant le segment SL, et un segment à ruban externe SM s'étendant et se succédant selon la direction longitudinale et comportant respectivement un ruban enterré RL et un ruban externe RM. Ces rubans sont représentés aux figures 9 et 10. Les deux segments sont mutuellement alignés selon la direction DZ.

Chacun d'eux comporte une couche à indice accru GL ou GM située entre deux couches de confinement l'une inférieure CB et l'autre supérieure CS. L'indice accru considéré ici est un indice de réfraction $n_1$ et il est accru par rapport à celui des couches de confinement de manière à limiter l'extension verticale d'un mode guidé unique selon lequel une onde optique doit se propager longitudinalement dans ce ruban.

La couche à indice accru GL et la couche de confinement supérieure CS du ruban enterré RL sont limitées transversalement entre deux blocs de confinement latéral 4 faisant parties de la plaquette 2. Ces blocs ont un indice de réfraction $n_2$ inférieur audit indice accru de manière que cette limitation transversale de la couche à indice accru limite l'extension transversale du mode guidé par ce ruban. Ils sont par ailleurs réalisés de manière à confiner dans le ruban enterré un courant d'alimentation circulant verticalement dans la plaquette. Ceci peut être obtenu de manière connue par un accroissement de la résistivité électrique d'un matériau constitutif de ces blocs, et/ou par la formation d'une jonction semiconductrice bloquante dans ces blocs.

La couche de confinement supérieure CS du ruban externe RM a un indice de réfraction $n_2$ supérieur à l'indice $n_3$ d'un espace, par exemple gazeux, extérieur à la plaquette. Elle est limitée transversalement entre deux évidements 14 et 16 de la plaquette appartenant à cet espace extérieur et laissant subsister la couche à indice accru GM et la couche de confinement inférieure CB. Cette limitation transversale de la couche de confinement supérieure limite l'extension transversale du mode guidé par ce ruban.

Toutes ces couches ont été formées par des dépôts épitaxiaux sur un substrat non représenté. Ce substrat et la couche de confinement inférieure sont par exemple du type n. La couche de confinement supérieure CS est par exemple du type p de même qu'une couche de contact fortement dopée 6 qui a été déposée sur cette couche de confinement.

Le dispositif à fabriquer comporte aussi des électrodes EL, EM et EG formées au-dessus et au-dessous de la plaquette dans chacun des segments. Plus précisément les électrodes EL et EM sont respectivement formées sur le ruban enterré RL et sur le ruban externe RM et l'électrode inférieure EG est commune aux deux segments.

Le ruban externe RM est formé par les opérations suivantes :

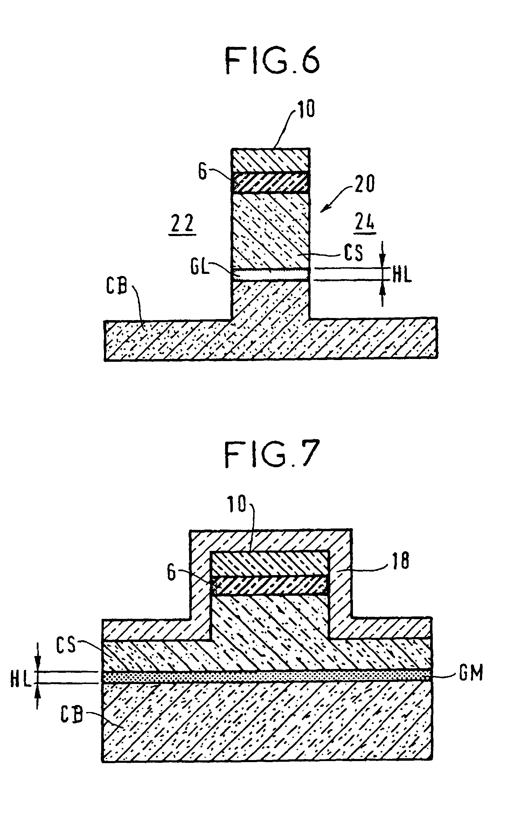

- dépôt de la couche de confinement inférieure CB, formation de la couche à indice accru GL, GM par un dépôt une gravure et un dépôt, dépôts de la couche de confinement supérieure CS, d'une couche de contact 6 à fort dopage et d'une couche de délimitation diélectrique 8 représentée à la figure 2 et surmontant la couche de confinement supérieure dans les deux segments,
- gravure de cette couche de délimitation pour former dans le segment à ruban externe SM une bande de délimitation 10 coïncidant transversalement avec le ruban externe RM à former,
- et attaque de la plaquette par un milieu d'attaque épargnant la bande de délimitation 10. Cette attaque est limitée en profondeur en deçà de la couche à indice accru GL, GM. Elle fait apparaître deux évidements latéraux initiaux 14 et 16 représentés à la figure 5 et situés de part et d'autre du ruban externe RM. Elle sera désignée ci-après comme étant une première attaque.

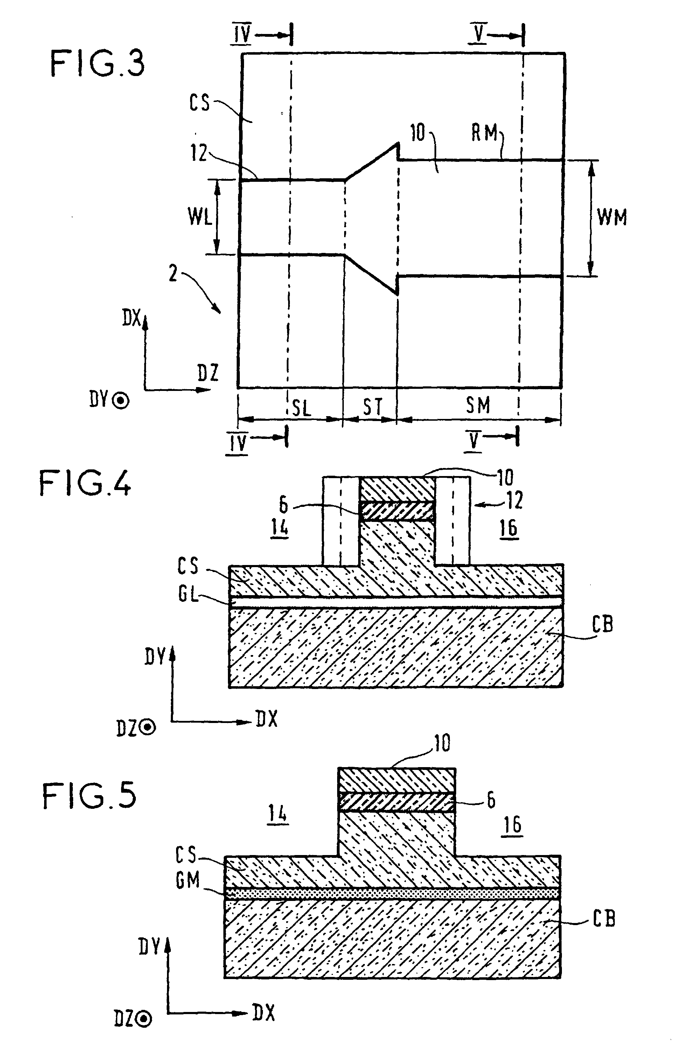

Pour réaliser un autoalignement des rubans RL et RM, la gravure de la couche de délimitation est effectuée pour former aussi la bande de délimitation 10 dans le segment à ruban enterré SL en faisant coïncider transversalement cette bande avec le ruban enterré RL à former. Il en résulte que la première attaque dégage ensuite dans ce premier segment une amorce de ruban enterré 12. Cette amorce est représentés à la figure 4. Elle fait saillie entre les deux évidements latéraux initiaux 14 et 16 qui sont limités en profondeur en deçà de la couche à indice accru GL.

Le ruban enterré est ensuite formé par les opérations suivantes :

- Dépôt d'une couche de protection 18 dans les deux segments SL et SM.
- Gravure de cette couche de protection 18 pour ne la laisser subsister que dans le segment à ruban externe RM.
- Attaque de la plaquette par un milieu d'attaque épargnant la couche de protection. Cette deuxième attaque est poursuivie en profondeur au-delà de la couche à indice accru GL de manière à dégager dans le segment à ruban enterré SL un corps de ruban enterré 20. Ce corps est représenté à la figure 6. Il fait saillie entre deux évidements latéraux approfondis 22 et 24.
- Enfin dépôt sélectif d'au moins un matériau 4 par une méthode de dépôt sélective qui est inefficace sur les parties subsistantes des couches de délimitation 10 et de protection 18. Ce dépôt constitue les blocs de confinement latéral 4 en remplissant lesdits évidements latéraux approfondis.

Bien entendu, selon le type de laser à ruban enterré à réaliser, on peut constituer les blocs de confinement latéral par dépôt d'une succession de matériaux différents les uns des autres.

Les couches de délimitation 10 et de protection 18 sont typiquement constituées de matériaux diélectriques. Une opération d'élimination au moins partielle des parties subsistantes des couches de délimitation et de protection est alors effectuée après le dépôt du matériau de confinement latéral 4 et avant la formation des électrodes supérieures EL et EM.

Les couches de confinement CB et CS sont par exemple constituées de phosphure d'indium InP, la couche à indice accru GL, GM d'alliages ternaires ou quaternaires tels que GaInAS, GaInAsP, ou d'une superposition de puits quantiques constitués par de tels alliages et séparés par des barrières de phosphure d'indium, la couche de délimitation 10 de nitrure de silicium Si3N4 et la couche de protection 18 de silice SiO2, au moins un matériau de confinement latéral 4 étant constitué par exemple de phosphure d'indium semi-isolant.

Typiquement la couche à indice accru GL, GM présente deux longueurs d'onde caractéristiques différentes telles que 1560 et 1510 nm respectivement dans les deux segments SL et SM de manière que le segment à ruban enterré SL constitue un laser pour émettre une lumière infrarouge et que le segment à ruban externe SM constitue un modulateur pour moduler cette lumière.

La présente invention permet de raccorder avec un minimum de pertes deux segments de guide tels que les rubans enterré et externe précédemment décrits. Elle peut cependant trouver d'autres applications. C'est pourquoi elle a de manière générale pour objet un guide optique, ce guide étant monolithique et comportant en succession dans un sens direct de sa longueur un segment arrière, un segment de transition et un segment avant, ce segment de transition se raccordant à ce segment avant dans une zone de raccordement, ce guide présentant en chaque point de sa longueur une largeur et un facteur de confinement latéral, cette largeur ayant une première valeur dans ce segment arrière et une deuxième valeur supérieure à la première dans ce segment avant, ce facteur de confinement étant constitué par le rapport d'une puissance optique confinée dans cette largeur à une puissance optique totale, ces puissances optiques étant celles d'une même lumière guidée par ce guide, ce facteur étant plus grand dans ce segment arrière que dans ce segment avant, ce guide étant caractérisé par le fait que sa largeur atteint dans ce segment de transition au voisinage de cette zone de raccordement une valeur maximal supérieure à cette deuxième valeur.

Il peut être noté qu'un document D1 antérieur à la présente invention décrit un ensemble d'injection de lumière dans lequel, comme selon cette invention, la largeur d'un guide (représenté à droite sur la figure 2 de ce document) atteint, au voisinage (et plus particulièrement au contact) d'un système optique parcouru par la même lumière que ce guide (à gauche sur la même figure), une valeur supérieure à une valeur présentée au contact de ce guide par la largeur de ce système: D1: ELECTRONICS LETTERS., vol. 30, no. 18, 1. Septembre 1994, pages 1515-1516, J.-M. CHEONG ET.AL.: "High alignment tolerance coupling scheme for multichannel laser diode/singlemode fibre modules using a tapered waveguide array". Ledit système optique de ce document est un système concentrateur de lumière présentant une forme extérieure en entonnoir et une structure interne complexe pour compenser un défaut aléatoire de l'alignement transversal entre ledit guide de cet ensemble d'injection et une diode laser dont la lumière doit être injectée dans ce guide. Ladite valeur présentée par la largeur de ce système au contact de ce guide est présentée seulement localement et elle est égale à la valeur présentée uniformément par la largeur de ce guide à distance de ce système.

Pour un point de la longueur du guide par lequel passe un plan transversal P dans lequel sont définies des coordonnées x et y, les abscisses x étant définies selon la direction transversale DX, le facteur de confinement latéral (V) est défini par l'égalité

$$V = \int_{x1}^{x2} \int_{-\infty}^{+\infty} |E|^2 . dx.dy \Big/ \iint_{P} |E|^2 . dx.dy$$

$x_1$ et $x_2$ étant les abscisses des deux extrémités de la largeur du guide de sorte que $W = x_2 - x_1$, et E désignant le champ électrique optique de la lumière guidée.

Dans certaines limites de la largeur W correspondant à un guidage monomodal ce facteur croit avec cette largeur. Il croit aussi avec l'épaisseur du ruban et avec un écart d'indice constitué par la différence entre l'indice de ruban et l'indice de confinement latéral.

Dans le cas simple où un ruban homogène présente une section rectangulaire entourée par un matériau de confinement homogène, où il assure un guidage monomodal, et où son épaisseur H reste suffisamment petite par rapport à sa largeur W, ce facteur vaut

$$V = 2\pi \, H \, \lambda^{-1} \, (n_1^2 - n_2^2)^{1/2} \, W$$

$n_1$ et $n_2$ étant les indices de réfraction du ruban et du matériau de confinement et $\lambda$ étant la longueur d'onde de la lumière guidée.

Dans le cas typique où $n_1$ et $n_2$ restent très voisins d'une valeur moyenne $n_m$ constante et où un écart d'indice est défini par l'égalité $\Delta n = n_1 - n_2$, le facteur de confinement vaut $V = k.H.W.\Delta n^{1/2}$, k étant un coefficient indépendant des dimensions transversales et valant $k = 2\pi \, \lambda^{-1}.n_m^{1/2}$

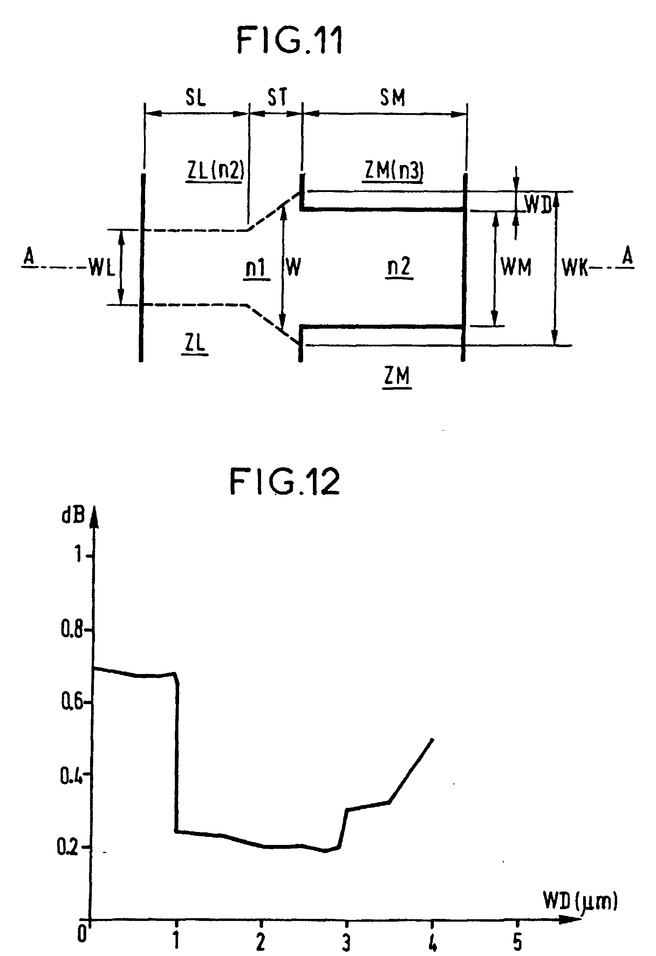

Le segment arrière SL, le segment de transition ST et le segment avant SM se succèdent dans le sens direct DZ (voir figure 11). La largeur du guide présente une première valeur WL dans le segment arrière et une deuxième valeur WM supérieure à la première dans le segment avant. De préférence la largeur du guide croit progressivement dans le segment de transition dans le sens direct à partir de cette première valeur jusqu'à une valeur maximale WK atteinte au voisinage de la zone de raccordement et supérieure à cette deuxième valeur. De préférence encore le guide présente, au moins au voisinage de la zone de raccordement, une symétrie par rapport à un plan longitudinal A.

Plus particulièrement le guide est formé en chaque partie de sa longueur par un ensemble de couches superposées telles que CB, GL, CS dans sa partie arrière constituée par les segments arrière et de transition et telles que CB, GM, CS, 6, 10 dans son segment avant. Ces couches ont des épaisseurs respectives. L'une au moins de ces couches inclut un ruban tel que GL dans le segment arrière et RM dans le segment avant. Ce ruban s'étend selon la longueur du guide sur l'épaisseur de cette couche en présentant une largeur limitée. Il présente un indice de réfraction constituant un indice de ruban et il est entouré latéralement par des zones de confinement latéral telles que 4 dans le segment arrière et 14 et 16 dans le segment avant. Ces zones présentent des indices de réfraction constituant des indices de confinement. Ces derniers sont plus faibles que l'indice de ruban. La largeur du guide est une largeur de ruban effective définie dans un ensemble comportant au moins une couche et constitué par la ou les couches incluant desdits rubans. Le guide présente une configuration de confinement dans chaque plan transversal passant par un point de sa longueur. Cette configuration est celle desdites couches, rubans, et zones de confinement avec leurs épaisseurs et leurs indices de réfraction, à l'exception de la largeur du guide. Elle est uniforme d'une part dans la partie arrière du guide, d'autre part dans le segment avant et elle y est telle que le facteur de confinement latéral est plus grand dans le segment arrière que dans le segment avant. Typiquement la partie arrière se raccorde directement au segment avant.

Dans le dispositif précédemment donné en exemple le guide optique est toujours monomodal pour une lumière guidée présentant une longueur d'onde de 1550 nm. Le segment arrière SL a un coeur homogène qui est constitué par la couche GL et qui a l'indice de réfraction $n_1$. Ce coeur est entouré par un ensemble optiquement homogène de matériaux de confinement présentant un indice de réfraction $n_2$. Il présente une largeur WL et une épaisseur HL. Ces dimensions et son écart d'indice $\Delta nL = n_1 - n_2$ lui confèrent un facteur de confinement VL.

Dans le segment avant SM la largeur du guide est la largeur WM du ruban externe RM. Un facteur de confinement vertical est essentiellement défini par l'épaisseur HM de la couche GM et par un écart d'indice entre cette couche et les couches adjacentes. Le facteur de confinement latéral VM dépend essentiellement d'une part de l'écart d'indice

$$\Delta nM = n_2 - n_3$$

d'autre part de l'épaisseur HM de ce ruban. Il est inférieur à VL.

Dans le segment de transition ST, le facteur de confinement selon la direction transversale DX dépend essentiellement de l'épaisseur HL et de l'écart d'indice $\Delta nL$. La largeur du ruban GL dans ce segment y constitue la largeur du guide. Elle croit dans le sens direct, par exemple linéairement, à partir de WL jusqu'à une largeur maximale WK supérieure à WM.

La perte de lumière au passage entre les segments SL et SM décroît lorsque la longueur L du segment de transition ST croît. Cette longueur doit cependant être limitée pour éviter un encombrement excessif du dispositif fabriqué. Dans le cas d'un ensemble laser modulateur semiconducteur tel que donné en exemple elle semble devoir être comprise entre 100 et 500 µm.

Cette perte de lumière varie aussi en fonction d'un excès terminal de largeur 2WD = WK - WM du segment de transition par rapport au segment avant. Cette variation est représentée à la figure 12, les valeurs de la perte étant portées en ordonnées en décibels, et l'excès de largeur WD étant porté en abscisses en micromètres. Ces valeurs de perte ont été fournies par un modèle informatique dans le cas des valeurs suivantes des autres paramètres :

**5**

| WL = 2 µm | ΔnL = 0,04 | HL = 0,2 µm. |
|-----------|-------------|---------------|
| WM = 4 µm | ΔnM = 0,005 | HM = 2 µm. |
| L = 0,2 mm. | | |

Il apparaît sur cette figure que le demi excès de largeur WD doit de préférence être compris dans une plage s'étendant de 1 à 3 µm.

De manière plus générale il semble préférable que cet excès soit compris entre 0,1 µm et 30 µm.

Par ailleurs, pour faciliter la réalisation du dispositif, il peut être accepté ou préféré que, dans la zone de raccordement où l'on passe du segment de transition au segment avant, le point de changement de largeur où se localise la diminution de la largeur du guide soit légèrement décalé vers l'avant ou l'arrière par rapport au point de changement de confinement où se localise la diminution du facteur de confinement. Cette diminution de la largeur du guide pourrait aussi être progressive.

Comme dans le cas précédemment décrit, le guide selon l'invention est typiquement inclus dans un dispositif pour traiter une lumière guidée dans ce guide. La lumière à traiter peut se propager selon la direction longitudinale dans ledit sens direct ou dans le sens opposé. Comme dans ledit cas le traitement effectué peut consister à engendrer et à moduler cette lumière. Plus généralement il comporte la réalisation de deux opérations successives concernant cette lumière, l'une étant réalisée dans le segment arrière, l'autre dans le segment avant, la différence entre les configurations de confinement de ces deux segments étant rendue nécessaire par les natures respectives de ces deux opérations.

## Revendications

**1.** Guide optique, ce guide étant monolithique et comportant en succession dans un sens direct (DZ) de sa longueur un segment arrière (SL), un segment de transition (ST) et un segment avant (SM), ce segment de transition se raccordant à ce segment (SM) avant dans une zone de raccordement, ce guide présentant en chaque point de sa longueur une largeur (W) et un facteur de confinement latéral (V), cette largeur ayant une première valeur (WL) dans ce segment arrière (SL) et une deuxième valeur (WM) supérieure à la première dans ce segment avant (SM), ce facteur de confinement étant constitué par le rapport d'une puissance optique confinée dans cette largeur à une puissance optique totale, ces puissances optiques étant celles d'une même lumière guidée par ce guide, ce facteur étant plus grand dans ce segment arrière (SL) que dans ce segment avant (SM), ce guide étant **caractérisé par le fait que** sa largeur (W) atteint dans ce segment de transition au voisinage de cette zone de raccordement une valeur maximale (WR) supérieure à cette deuxième valeur.

**2.** Guide selon la revendication 1, la largeur (W) de ce guide croissant progressivement dans le segment de transition (ST) dans le sens direct à partir de ladite première valeur jusqu'à ladite valeur maximale (WR).

**3.** Guide selon la revendication 1, ce guide présentant au moins au voisinage de la zone de raccordement une symétrie par rapport à un axe longitudinal (A).

**4.** Guide selon la revendication 1, ce guide étant formé en chaque point de sa longueur par un ensemble de couches superposées (CB, GL, CS, GM, 6, 10) présentant des épaisseurs respectives, l'une au moins de ces couches superposées incluant un ruban (GL, RM) s'étendant selon la longueur du guide sur l'épaisseur de cette couche en présentant une largeur limitée, ce ruban présentant un indice de réfraction constituant un indice de ruban, ce ruban étant entouré latéralement par des zones de confinement latéral (4, 14, 16) présentant des indices de réfraction constituant des indices de confinement plus faibles que l'indice de ruban, ladite largeur du guide étant une largeur de ruban effective définie dans un ensemble comportant au moins une couche et constitué par la ou les couches incluant desdits rubans, le guide présentant audit point de sa longueur une configuration de confinement, cette configuration étant celle de ces couches, rubans, zones de confinement avec leurs épaisseurs et indices de réfraction, à l'exception de la largeur du guide, dans un plan transversal passant par ce point, cette configuration de confinement étant uniforme d'une part dans une partie arrière constituée par l'ensemble desdits segments arrière (SL) et avant (SM), d'autre part dans ledit segment avant (SM).

**5.** Guide selon la revendication 1, ledit segment de transition (ST) se raccordant directement au dit segment avant (SM).

**6.** Guide selon la revendication 1, ce guide étant inclus dans un dispositif pour effectuer, dans chacun desdits segments arrière (SL) et avant (SM), un traitement d'une lumière guidée dans ce guide (G).

**7.** Guide selon la revendication 6, ce guide étant formé dans un substrat semiconducteur (2), un ruban enterré et un ruban externe constituant respectivement les segments arrière (SL) et avant (SM) de ce guide.

**8.** Guide selon la revendication 7, lesdits segments arrière (SL) et avant (SM) constituant respectivement un émetteur laser pour engendrer une lumière et un modulateur optique pour moduler cette lumière.

**Patentansprüche**

**1.** Optischer Leiter mit monolithischem Aufbau, der in einer Durchgangsrichtung (DZ) seiner Länge ein hinteres Segment (SL), ein Übergangssegment (ST) und ein vorderes Segment (SM) aufweist, wobei das Übergangssegment mit dem vorderen Segment (SM) in einer Anschlusszone verbunden ist, wobei der Leiter an jedem Punkt seiner Länge eine Breite (W) und einen seitlichen Einschließungsfaktor (V) aufweist, wobei die Breite in dem hinteren Segment (SL) einen ersten Wert (WL) und in dem vorderen Segment (SM) einen zweiten Wert (WM) aufweist, der größer als der erste Wert ist, wobei der Einschließungsfaktor gebildet ist durch das Verhältnis einer in dieser Breite eingeschlossenen optischen Leistung zu einer optischen Gesamtleistung, und wobei diese optischen Leistungen die eines gleichen von diesem Leiter geführten Lichtes sind, wobei dieser Faktor in dem hinteren Segment (SL) größer als in dem vorderen Segment (SM) ist, **dadurch gekennzeichnet, dass** die Breite (W) des Leiters in dem Übergangssegment in der Nähe der Anschlusszone einen Maximalwert (WR) oberhalb des zweiten Wertes erreicht.

**2.** Leiter nach Anspruch 1, bei dem die Breite (W) dieses Leiters in dem Übergangssegment (ST) ausgehend von dem ersten Wert bis zu dem Maximalwert (WR) progressiv zunimmt.

**3.** Leiter nach Anspruch 1, der wenigstens in der Nähe der Anschlusszone eine Symmetrie in Bezug auf eine Längsachse (A) aufweist.

**4.** Leiter nach Anspruch 1, der an jedem Punkt seiner Länge durch eine Anordnung von übereinanderliegenden Schichten (CB, GL, CS, GM, 6, 10) mit jeweiligen Dicken gebildet ist, wobei wenigstens eine dieser übereinanderliegenden Schichten einen Streifen (GL, RM) enthält, der sich in Längsrichtung des Leiters über die Dicke dieser Schicht erstreckt und eine begrenzte Breite aufweist, wobei dieser Streifen einen Brechungsindex aufweist, der einen Streifenindex darstellt, dieser Streifen seitlich von seitlichen Einschließungszonen (4, 14, 16) umgeben ist, die Brechungsindizes aufweisen, die niedrigere Einschließungsindizes darstellen als der Streifenindex, wobei die Breite des Leiters eine effektive Streifenbreite ist, die in einer Anordnung definiert ist, die wenigstens eine Schicht umfasst und durch die Schicht oder Schichten, die die Streifen enthalten, gebildet ist, wobei der Leiter an diesem Punkt seiner Länge eine Einschließungskonfiguration aufweist, wobei diese Konfiguration die dieser Schichten, Streifen, Einschließungszonen mit ihren Dicken und Brechungsindizes, mit Ausnahme der Breite des Leiters, in einer durch diesen Punkt verlaufenden Querebene ist, wobei diese Einschließungskonfiguration einerseits in einem hinteren Bereich, der durch die Anordnung des hinteren Segments (SL) und vorderen Segments (SM) gebildet ist, und andererseits in dem vorderen Segment (SM) einheitlich ist.

**5.** Leiter nach Anspruch 1, bei dem das Übergangssegment (ST) direkt mit dem vorderen Segment (SM) verbunden ist.

**6.** Leiter nach Anspruch 1, enthalten in einer Vorrichtung zum Durchführen, in dem hinteren Segment (SL) und in dem vorderen Segment (SM), einer Verarbeitung eines in diesem Leiter (G) geführten Lichts.

**7.** Leiter nach Anspruch 6, der in einem Halbleitersubstrat (2) gebildet ist, wobei ein vergrabener Streifen und ein externer Streifen jeweils das hintere (SL) und vordere (SM) Segment dieses Leiters bilden.

**8.** Leiter nach Anspruch 7, bei dem das hintere Segment (SL) und das vordere Segment (SM) jeweils einen Lasersender zum Erzeugen eines Lichtes und einen optischen Modulator zum Modulieren dieses Lichtes bilden.

**Claims**

1. An optical waveguide, the waveguide being monolithic and comprising in succession, in a forward direction (DZ) along its length, a rear segment (SL), a transition segment (ST), and a front segment (SM), the transition segment being connected to the front segment (SM) in a connection zone, the waveguide having a width (W) and a lateral confinement factor (V) at each point along its length, said width having a first value (WL) in the rear segment (SL), and a second value (WM) that is greater than the first value, in the front segment (SM), said confinement factor being constituted by the ratio of optical power confined in the width divided by total optical power, the optical powers being those of the same light guided by the waveguide, said factor being greater in the rear segment (SL) than in the front segment (SM), said waveguide being **characterized by** the fact that its width (W) reaches, in the transition segment in the vicinity of the connection zone, a maximum value (WR) that is greater than said second value.

2. A waveguide according to claim 1, the width (W) of the guide increasing progressively in the transition segment (ST) in the forward direction from said first value to said maximum value (WR).

3. A waveguide according to claim 1, the waveguide being symmetrical about a longitudinal axis (A) at least in the vicinity of the connection zone.

4. A waveguide according to claim 1, the waveguide being formed at each point along its length by a set of superposed layers (CB, GL, CS, GM, 6, 10) having respective thicknesses, at least one of the superposed layers including a ridge (GL, RM) extending along the length of the waveguide over the thickness of the layer and having a limited width, said ridge having a refractive index constituting a ridge index, the ridge being surrounded laterally by lateral confinement zones (4, 14, 16) having refractive indices constituting confinement indices that are lower than the ridge index, said width of the waveguide being an effective ridge width defined in a set that comprises at least one layer and that is constituted by the layer(s) including said ridge(s), the waveguide having a confinement configuration at said point along its length, the configuration being that of the layers, ridges, and confinement zones with their thicknesses and refractive indices, with the exception of the width of the waveguide, in a cross-sectional plane including that point, the confinement configuration being uniform both in a rear portion constituted by both said rear and front segments (SL, SM), and also in said front segment (SM).

5. A waveguide according to claim 1, said transition segment (ST) being connected directly to said front segment (SM).

6. A waveguide according to claim 1, the waveguide being included in a device for performing, in each of said rear and front segments (SL, SM), processing of a light guided in the waveguide (G).

7. A waveguide according to claim 6, the waveguide being formed in a semiconductor substrate (2), a buried ridge and an external ridge respectively constituting the rear segment (SL) and the front segment (SM) of the waveguide.

8. A waveguide according to claim 7, said rear segment (SL) and said front segment (SM) respectively constituting a laser emitter for generating light and an optical modulator for modulating said light.

# FIG.1

# FIG.2

FIG.3

FIG.4

FIG.5

# FIG.6

# FIG.7

FIG.8

FIG.9

FIG.10

# FIG.11

# FIG.12